# EUROPEAN PATENT SPECIFICATION

(11) **EP 1 274 580 B1**
(45) Date of publication and mention of the grant of the patent: **08.02.2006**
(21) Application number: 00963628.3
(22) Date of filing: 20.09.2000
(51) Int. Cl.: B32B 37/00, B30B 5/06, D04H 3/04

(54) **PRESSURE LAMINATOR APPARATUS**
DOPPELBANDPRESSE
APPAREIL DE CONTRECOLLAGE A PRESSION

(30) Priority: 20.09.1999 US 155364 P
(43) Date of publication of application: 15.01.2003
(73) Proprietor: HUNTER DOUGLAS INC., Upper Saddle River, NJ 07458-0740 (US)
(72) Inventor: COLSON, Wendell, B., Weston, MA 02493 (US); DANN, Kevin, Denver, CO 80230 (US)
(74) Representative: Smith, Samuel Leonard
(86) International application number: PCT/US2000/025680
(87) International publication number: WO 2001/021399

(56) References cited:
- EP-A- 0 255 596
- EP-A- 0 470 584
- WO-A-00/41523
- DE-A- 3 046 431
- DE-A- 3 046 432
- JP-A- 1 210 318
- JP-A- 63 267 525
- US-A- 3 591 434
- US-A- 4 498 941
- US-A- 4 687 528
- US-A- 5 558 016

## Description

This invention relates to a lamination apparatus and in particular to a dual belt driven, continuous pressure lamination apparatus that utilizes pressure, heat and cooling to bond at least two substrates (plies) with an adhesive between the layers of the substrates. The laminator of the present invention overcomes many of the disadvantages of prior art laminators, including shrinkage of materials, and the like.

JP-A-01 210 318, JP-A-63 267 525, EP-A-0 255 596, US-A-4 687 528, EP-A-0 470 584, DE-A-30 46 431, DE-A-30 46 432, US-A- 3 591 434, US-A-4 498 941 and US-A-5 352 321 describe various pressure lamination arrangements.

More specifically, the present invention relates to an apparatus according to the preamble of claim 1.

Such an apparatus is known in particular from US-A-4 498 941. This known apparatus comprises a solid sealing ring around the upper and lower pressure box sections.

In order to improve the sealing of the upper pressure box section and the lamination of the substrates, the present invention provides a pressure lamination apparatus as defined in appended claim 1.

In this apparatus, the bladders improve the flexibility of the pressure seals in a simple and efficient way.

This invention relates to a lamination apparatus and in particular to a dual belt driven, continuous pressure lamination apparatus that utilizes pressure, heat and cooling to bond at least two substrates (plies) with an adhesive between the layers of the substrates.

The laminator of the present invention can be employed to make a variety of composite and/or reinforced materials. One or more of the component parts of the laminate (i.e., the substrates or plies) may be a woven fabric material, a non-woven fabric web, or a mat of fibers. Adhesive materials, preferably thermoplastic materials, are used to bond the various substrates in the laminate construct. These materials may be melted and remelted over and over. When used to laminate yarns, especially polymer yarns, thermoplastic copolyester adhesives are preferred, as these materials may be selected to have a melting temperature below the melting temperature of the yarns. Industrial type laminates that may be formed using the laminator of the present invention include natural and/or synthetic fabric-based, asbestos-based, glass-based, nylon-based, flame-retardant and/or flame-resistant based, and mixtures thereof. Laminates of other materials may also be prepared as will be appreciated by those having ordinary skill in the field.

Non-woven fabrics are one especially preferred class of materials used as the plies or substrates in the pressure laminator of the present invention. Non-woven fabrics are similar to woven and knitted fabrics in that all are planar, inherently flexible, porous structures composed of natural or synthetic fiber materials (i.e., yarns, threads, or filaments). Non-woven fabrics are unique in that they can be engineered to resemble woven or knitted fabrics, but they can also be made to have superior physical characteristics over woven or knitted fabrics. Thus, non-woven fabrics are highly influenced by the properties of their constituent fibers and the manner in which the non-woven fabric is prepared. Typical methods for preparing non-woven fabrics include mechanical, chemical and thermal interlocking of layers or networks of the fiber materials.

At least two non-woven fabric substrates may be used, one of the fabric substrate representing the weft strands and another representing the warp strands. The adhesive used to bond the non-woven substrates should be activated by heat during the lamination process. The combination of pressure, heating to activate the adhesive and rapid cooling of the joined substrates minimizes shrinkage and sets the yarn size in the final non-woven fabric laminate. In addition, because the laminate is being formed under pressure, the warp and weft yarns are forced into intimate contact, giving the final laminate the appearance of a woven product.

A lamination apparatus embodying the present invention has an outer housing or frame in which a rectangular pressure box is mounted. The shape of the box need not be rectangular, but this shape is currently preferred. The pressure box comprises two spaced apart sections, an upper section and a lower section, each of which has pressure seals along its four edges, and each of which is further provided with a plurality of both heating and cooling elements. Two counter rotating drive belts, an upper drive belt and a lower drive belt, contact one another at and together run through a space between the two sections of the pressure box. The belts are dimensionally larger (length and width) than the pressure box. This is necessary to permit pressurization of the box, both above and below the two belts. One belt is driven in a clockwise manner and the other belt is driven in a counterclockwise manner. Once the belts are in motion, one end of the pressure box is the inlet (feed) end and one end is the outlet end of the laminator.

The lower section of the pressure box is mounted rigidly to the frame or housing, whereas the upper section of the pressure box can be adjusted as necessary to permit access to the interior of the box. Normally, the sections are spaced apart sufficiently to permit passage of the drive belts there through under pressure (or in a depressurized state), with or without material to be laminated there between.

During the lamination process, substrate materials to be laminated are passed through a pressure seal at the inlet end of the pressure box, and into the space between the two drive belts. Air pressure applied to the upper and lower sections of the pressure box is used to compress the air-impermeable belts toward one another, creating a diaphragm effect between the belts, thereby compressing the substrates situated there between. The upper and lower sections of the pressure box are equipped with a plurality of heating and cooling elements, which are used to activate and set the thermoplastic adhesive between the substrate layers.

In an especially preferred embodiment, the plurality of heating and cooling bars located in the lower section of the pressure box are rigidly mounted, whereas the plurality of heating an cooling bars in the upper section of the pressure box are mounted so as to float on top of the materials being laminated. This arrangement has been found to be especially useful in the preparation of non-woven fabrics. Shrinkage is minimized or eliminated and the final laminate has the physical characteristics (feel and appearance) of a thermomechanically finished fabric.

Advantageously, at least about 10%, preferably at least about 25% and most preferably about 50% of the box interior at the inlet end of the pressure box is provided with heat bars, and the remainder of the pressure box, again, at least about 10%, preferably at least about 25% and most preferably about 50% of the box interior, is provided with cooling bars. The heating bars are ideally located at the inlet end of the pressure box and the cooling bars are ideally located at the outlet end of the pressure box. If desired, multiple zones of heating and cooling could be included within the pressure box; e.g., heat/cool, heat/cool, heat/cool, etc.

Movement of the two belts through the pressure box allows for the continuous feeding of substrate materials and thermoplastic adhesive enter the laminator through an entry pressure seal. Once therein, the substrates are nipped or pressed together by the diaphragm effect caused by the pressure applied to the belts. The pressed substrates are then heated under pressure, melting the thermoplastic adhesive. This allows the substrate layers to come closer together, with at least some portions of the warp and weft yarn strands becoming coplanar or nearly coplanar. The heated substrates are then cooled, while still under pressure, forming the final laminate. The cooled laminate exits the pressure box through an exit pressure seal, where it is collected as desired.

When two or more non-woven polyester substrates (e.g., at least one warp substrate and at least one weft substrate) are laminated in this apparatus, the thickness of the laminate at the outlet end of the laminator is at least 5%, preferably at least 10% and most preferably at least about 20% less than the combined thickness of the substrates and thermoplastic adhesive, as measured at the inlet end of the laminator.

The current rectangular pressure has a pressure area of about 967800 mm² (1500 square inches (in²)). The drive belts, which are substantially non-porous, are pressurized from both sides of the pressure box with air (or other fluid medium) pressure of at least 13.78 kPa (2 psi), preferably at least about 34.45 kPa (5 psi), and most preferably at least about 68.9 kPa (10 psi). Higher pressures can be achieved with modification of the equipment to support and sustain the same. This pressure applied to the belts is equivalent to a compressive weight (force) ranging from about 2268 kg (5000 lbs) to about 22680 kg (50,000 lbs), applied over the 967800 mm² (1500 in²) area of the current pressure box. For laminating non-woven fabrics, a compressive force from about 4536 kg (10,000 lbs) to about 11340 kg (25,000 lbs) is typical, and a compressive force of about 6804 kg (15,000 lbs) (at 68.9 kPa (10 psi) gauge) has been found to be especially preferred to date. This is important because in a traditional laminator, which uses top and bottom platens, if a weight of 6804 kg (15,000 lbs) was placed on the top platen to provide the compressive force to effect lamination, any belt running hereunder would likely break. Traditional high pressure laminators usually employ a series of actions; move, stop, press; move, stop, press; etc., when operating in a "continuous" manner.

In the present invention, the use of a fluid pressure medium, e.g., air (or other gas, e.g., steam) or liquid (e.g., water, oil, etc), allows the belts to move, even though being pressured from both the top and the bottom. The belts of the present laminator slide through, even though they encounter forces that would break a belt in a conventional laminator.

This invention may be used to manufacture non-woven fabrics using the pressure lamination apparatus. The pressure laminator of the present invention has been specifically designed to permit the permanent joining of at least two non-woven fabric substrates with an adhesive between the fabric substrates, with little or no shrinkage occurring, during the lamination process. While not wishing to be bound by theory, it is believed that shrinkage is prevented or limited herein, due to the high pressure on the belts, which prevents the laminate from slipping, thereby preventing or limiting shrinkage. The resulting non-woven composite fabric advantageously has the appearance of a woven fabric, but has superior strength characteristics there over.

While designed for a specific purpose, the pressure laminator of the present invention can have other uses, for example, printed circuit board substrate manufacture, decorative laminating, industrial laminating, and the like, as will be appreciated by those having ordinary skill in this art.

### BRIEF DESCRIPTION OF THE DRAWINGS

FIG. 1 is a side view of a preferred embodiment of the pressure box and drive belt system for the laminator of the invention in which eight heater bars (four in each section) and eight cooling bars (four in each section) are used for pressure lamination of non-woven fabric substrates;
FIG. 2 is an end view of the pressure box of Figure 1, which shows the pressure delivery system for the upper and lower sections of the pressure box;
FIG. 3 is a top view of the upper section of the pressure box of Figure 1, showing the spacing of the heating and cooling bars;
FIG. 4 is a side view of the pressure box of Figure 1, showing the mounting brackets for the upper section (displaceable) heating and cooling bars and the mounting brackets for the lower section (fixed) heating and cooling bars. Also shown is an example of a side sealing element;
FIG. 5 is a side view of the pressure box of Figure 1, showing an example of a pressure box inlet pressure seal element; and
FIG. 6 is a side view of the pressure box of Figure 1, showing an example of a pressure box outlet pressure seal.
FIGS. 7A, 7B and 7C illustrate aspects of the inflatable rubber bladder seal embodiment for the pressure box sections.

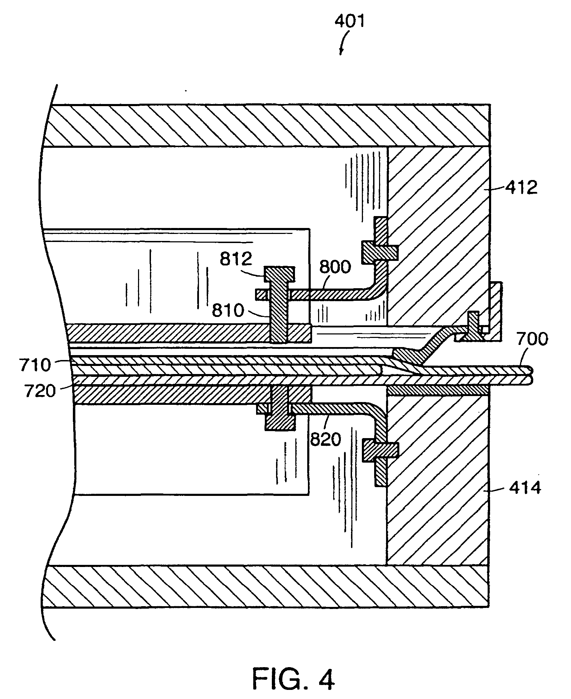

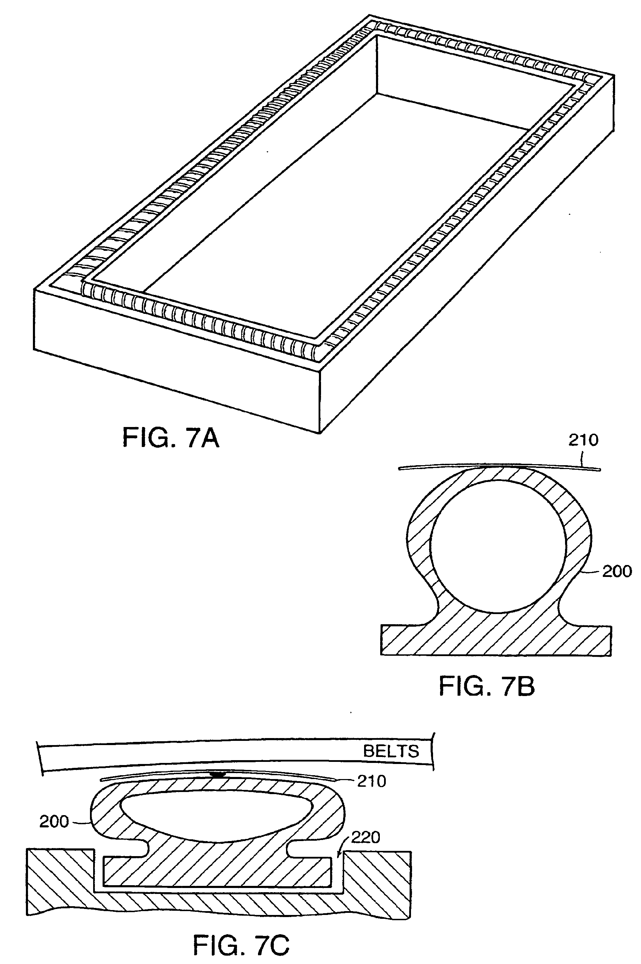

A bladder seal according to figs. 7A, 7B and 7C is used in the apparatus according to the invention whereas the seals illustrated on figs. 4,5 and 6 do not belong to the present invention.

### DETAILED DESCRIPTION OF THE PREFERRED EMBODIMENTS

As described above, the present invention is directed to a lamination apparatus and in particular to a dual belt driven, continuous pressure lamination apparatus that utilizes pressure, heat and cooling to bond at least two substrates (plies) with an adhesive between the layers of the substrates. If desired, the laminator of the present invention could also be used to stabilize a single ply material.

In general, the pressure lamination apparatus of this invention comprises a housing or frame in which a pressure box is mounted. The pressure box comprises two spaced apart pressure sections, an upper section and a lower section, wherein the space formed between the two pressure sections defines the lamination section. Two counter rotating drive belts, an upper drive belt and a lower drive belt, are rotatably mounted in the housing or frame, and the belts contact one another and are pulled through the lamination section by drive rollers mounted at the outlet end. A pressure generator is used to supplying air (or other fluid medium - liquid or gas) pressure to the upper and lower sections of the pressure box for compressing substrate materials carried between the two drive belts. Pressure is maintained because the box has pressure seals all around the points of contact with the belt.

In the rectangular box of one example, metal side seals are provided on the sides of both the upper and lower sections of the pressure box. Metal inlet and outlet seals are also provided on the upper and lower sections of the pressure box, ensuring that the desired diaphragm effect can be created therein. When pressurized, the apparatus caused the pressure lamination of substrates situated between the two belts.

In the rectangular box of another example, Teffon® (PTFE) or rubber coated metal side seals are provided on the sides of both the upper and lower sections of the pressure box. Rubber inlet and outlet seals are also provided on the upper and lower sections of the pressure box, ensuring that the desired diaphragm effect can be created therein. When pressurized, the apparatus caused the pressure lamination of substrates situated between the two belts.

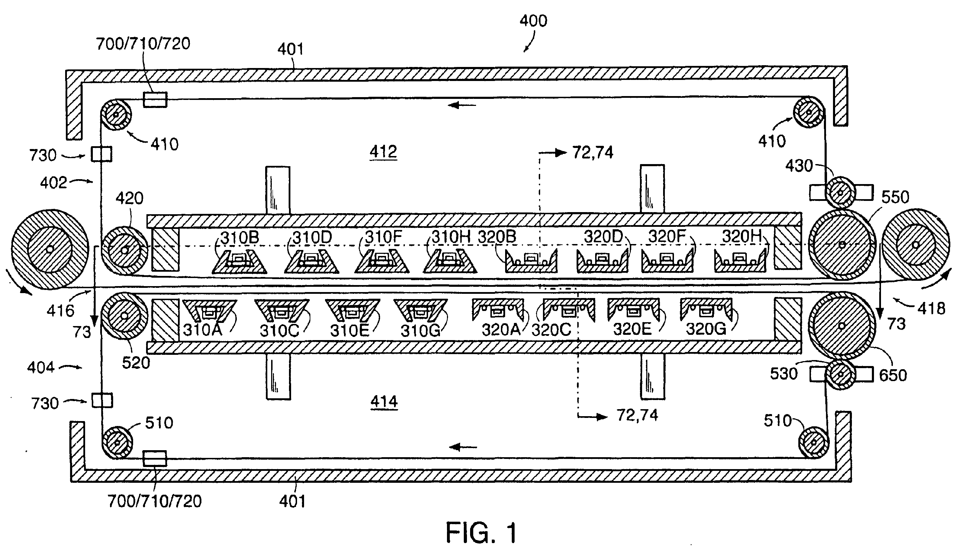

Referring to FIG. 1, a number of the essential components of the preferred pressure box 401 used in the pressure laminator of the present invention 400 are shown in cross-section. As illustrated, two rotatable belts, top belt 402 and bottom belt 404, mounted on a plurality of support rollers (top - 410, 420, 430; bottom - 510, 520, 530), are pulled through the pressure box 401, between the upper section 412 and the lower section 414, entering at the inlet end 416 and exiting at the outlet end 418, by their respective drive rollers 550 (top) and 650 (bottom).

Alignment of the two rotating belts 402 and 404, is maintained by an electric alignment system comprising an alignment carriage 100, alignment pivot 110, electric alignment servo 120 and electric alignment eyes 130. If either of the belts moves out of alignment, the electric eye 130 detects the same and activates the alignment servo, which causes the belt to be adjusted as necessary by lateral movement of the alignment carriage 100.

In the illustrated embodiment, eight spaced apart radiant heat bars (310A, 310B, 310C, 310D ... 310H) are shown at the inlet end 416 of pressure box 401 and eight spaced apart cooling bars (320A, 320B, 320C, 320D ... 320H) are shown at the outlet end 418 of pressure box 401. Four of the heat bars are rigidly mounted in the lower section 414 of the pressure box 401, namely heat bars 310A, 310C, 310E and 310G. The other four radiant heat bars (310B, 310D, 310F and 310H) are flexibly mounted such that they float above the upper belt, permitting materials of varied thickness to pass there under. Four of the cooling bars are rigidly mounted in the lower section 414 of the pressure box 401, namely cooling bars 320A, 320C, 320E and 320G. The other four cooling bars (320B, 320D, 320F and 320H) are flexibly mounted such that they float above the upper belt, permitting materials of varied thickness to pass there under.

As illustrated, the plurality of heating and cooling bars are preferably arranged in a staggered configuration. Thus, the substrate is heated from below, then above, then below, etc., and the cooling is accomplished in the same manner; the substrate is cooled from below, then above, then below, etc. This arrangement permits rapid and uniform heating, as well as rapid and uniform cooling of the substrate materials being laminated in the pressure laminator. The uniformity of heating and cooling under pressure leads to improved physical characteristics of the resulting laminates. In the case of non-woven fabrics laminated in this manner, shrinkage of the fabrics is held to a minimum and the resulting laminated material has the appearance and feel of a woven fabric.

In one embodiment, at least 75 percent of the belt width is heated and cooled by these elements. For example, on a 29-inch (0.74 m) wide belt, the central 22 inches (0.56 m) are heated and cooled. On a 76-inch (1.9 m) wide belt, the central 60 inches (1.5 m) would be heated and cooled. The Reliant ER177A heat bars (England) are each provided with a thermocouple to measure the temperature delivered to the belts. The cooling bars are each provided with water fed cooling pipes.

In another embodiment, the heating and cooling is accomplished by steam and cold water; each fed to an appropriate section of the laminator, in both the upper and lower sections. The use of a high-pressure gas and fluid medium creates both pressure and the requisite heating/cooling action that was alternatively achieved by the heating and cooling bars together with high-pressure air. If desired, infra-red heating may also be employed in this embodiment, and cooling may be accomplished by other means, including water spray, providing non-contact heating and/or cooling options.

The thickness of the PTFE impregnated fiberglass belt can be modified as desired, and depends on the nature of the materials being laminated and the desired operating speed in feet per minute (fpm). For laminating non-woven fabrics, a belt thickness ranging from 50.8 to 508 µm (2 to 20 mil), preferably 127 to 381 µm (5 to 15 mil) has been found satisfactory. Belts of 355.6 *µ*m (14-mil) thickness have been operated at 5 fpm (1.52 mpm), with a temperature of 380°F (193.3°C) being delivered to the substrates. Belts of 127 *µ*m (5-mil) thickness have been operated at 12 fpm (3.7 meters/min), with a temperature of 380°F (193.3°C) being delivered to the substrates. Optimum belt speeds of 50, 60, 70 ... 100 fpm (15.2, 18.3, 21.3, ... 30.48 mpm) can be achieved by modification of the belt thickness and/or composition. The optimum belt speed for non-woven fabric lamination is currently believed to be 60-70 fpm (18.3 - 21.3 mpm). Another way in which to achieve higher speeds is to simply increase the size of the laminator apparatus. The current preferred apparatus has a length of about 4 feet (1.2 meters). Increasing the size 2-10X would allow for faster operating speeds.

During the lamination process the substrate material may create a counter-pressure as any entrapped air in the substrates expands. To deal with this counter-pressure, at lease one (or both) of the PTFE (Teflon®) impregnated fiberglass drive belts used in the pressure laminator of the present invention can be modified on the outside edges, to comprise a thick (about 0.125 inch or 3.175 mm) porous glass fiber mat. This porous glass fiber mat allows the expanded air from the heated laminate to escape via this sideways (transverse) porosity.

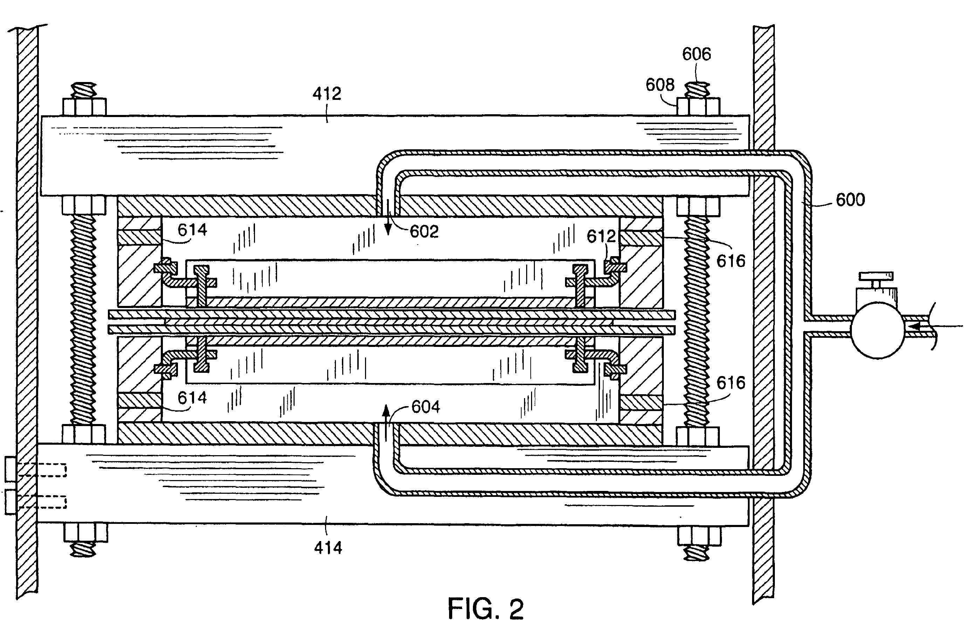

Figure 2 illustrates in cross-section, the end view of pressure box 401, showing in particular the air pressure feed line 600, and the preferred points of contact thereof 602 and 604 with the upper section 412 and lower section 414 of the pressure box, respectively. The pressure box is advantageously made out of metal, such as aluminum (from 50.8 to 127 mm (2 to 5 inches) thick) and is held together by a plurality of threaded steel rods and nuts 606 and 608. As shown in Figs. 2 and 4, the heating and cooling bars located in the lower section 414 of the pressure box are locked in place at each end by a fixed bracket 820. The heating and cooling bars located in the upper section 412 of the pressure box ride on a pin bracket mount 800/812, which allows upward motion of the bars, while gravity keeps the bars resting on the upper belt. A plurality of cooling water lines, inlet 614 and outlet 616 are also shown in Fig. 2. The electrical heating wires (not shown) are provided in a manner similar to the water lines.

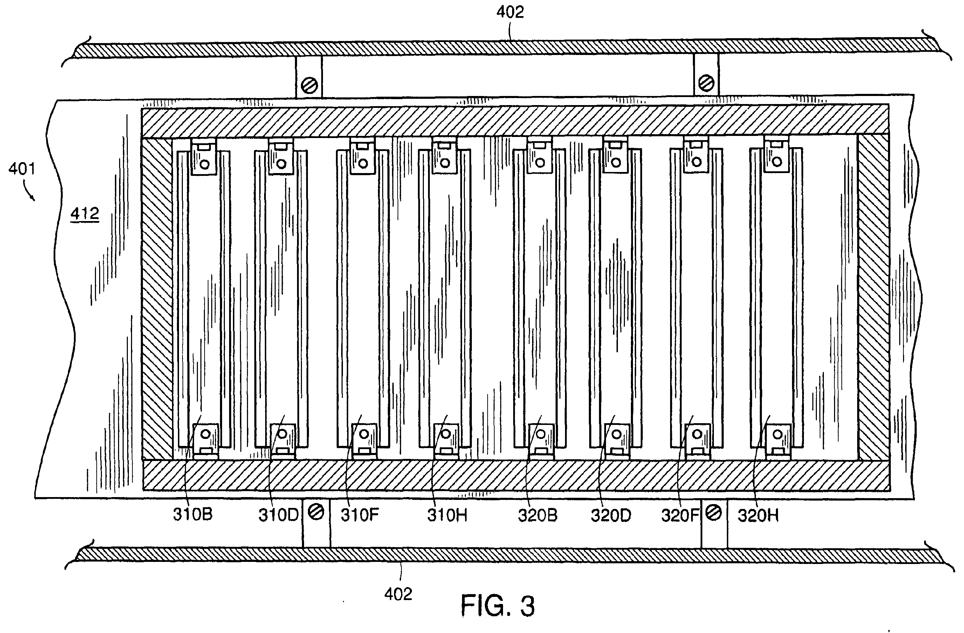

Figure 3 illustrates a top view of the interior of the upper section 412 of the pressure box 401, showing the currently preferred arrangement of the upper heating bars (310B, 310D, 310F and 310H) and cooling bars (320B, 320D, 320F and 320H). The pressurized box 401 is held together by steel bars 500 mounted to the threaded rods 606 shown in the four corners. Not shown in this illustration are the nuts that thread thereon. The sides 402 of the housing or frame, to which the steel bars and all rollers and controls are mounted, are also shown in this drawing.

Figure 4 illustrates, the pin bracket for the upper section, vertically displaceable, heating and cooling bars. As illustrated, the pin bracket comprises a steel mounting bracket 800, fixed at one end to the aluminum side wall of the upper section 412 of the pressure box. A slot (not shown) is provided near the opposite end of bracket 800, through which a post 810 rides. The post 810 is mounted to the top of the heating or cooling bar at one end and capped at the opposite end 812, thereby limiting the vertical displacement distance of the heating and cooling bars. The bracket for the lower section heating and cooling bars 820 is also a steel bracket, but it is rigidly attached to both the heating and cooling bars and the aluminum side wall of the lower section 414 of the pressure box.

A side pressure seal 850 is also illustrated in FIG. 4. This seal is formed from a high temper curved aluminum slat 700 (e.g., 0.008 x 1 3/8"- Venetian blind) sandwiched between 2 mil PTFE (Teflon®) tape 710 on the upper side and 254 *µ*m (10 mil) ultrahigh molecular weight polyethylene tape 720 on the bottom side. The seal is held in place by a steel bracket 870.

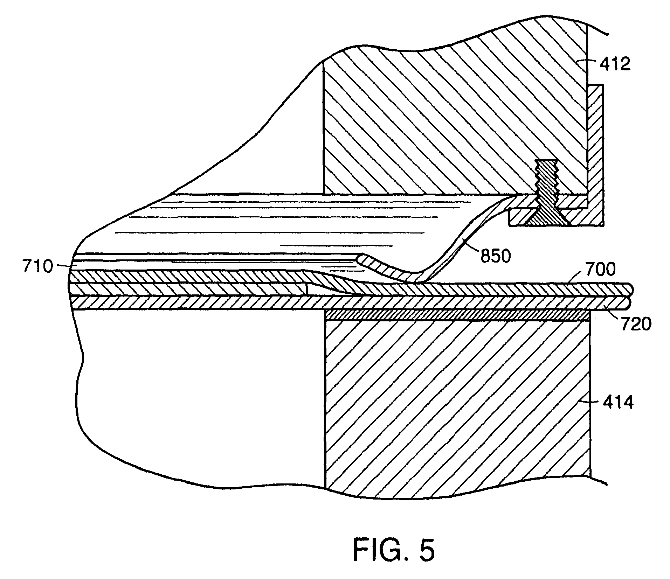

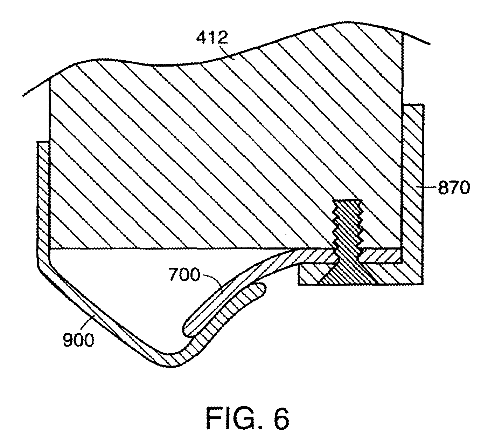

As illustrated in Figures 5 and 6, it has been discovered that the aluminum pressure seal taught in Figure 4 can be simplified, such that the side and inlet pressure seals consists predominantly of the curved aluminum slat 700 as previously described. The ultrahigh molecular weight polyethylene tape can be omitted and the PTFE tape can be omitted, except in the corners of the pressure box, where the tapes still prove useful. This improved side seal and inlet pressure seal is illustrated in Figure 5.

The exit pressure seal is shown in Figure 6. In addition to the curved aluminum slat 700, the belt side of the aluminum slat is coated with 127 *µ*m (5 mil) PTFE (Teflon®) fiberglass cloth 900, which extends beyond the end of the aluminum seal and mounts to the inside of the pressure box frame. This exit seal design keeps the drive belt from binding on the aluminum slat.

As discussed above, according to the present invention, these metal seals are replaced with one or more bladders, in particular inflatable rubber bladders, which offer several, advantages not provided by the above-described metal seals. See Figures 7A, 7B and 7C, which depict the positioning of one inflatable bladder 200 (e.g., silicone rubber) on the peripheral edges of the pressure box (Fig. 7A); the bladder 200 as inflated with the Teflon® coated metal slip plate 210 (Fig. 7B); and the bladder 200 as partially deformed via belt contact (Fig. 7C) creating the desired seal for the pressure box. A channel 220 is provided in the frame of the pressure box wall for attachment of the rubber bladder (Fig. 7C). An inflatable bladder of this type can be used for both the upper and the lower portions of the pressure box.

As the bladders are inflated against the belts, a uniform sealing pressure is created around the periphery of the pressure box. This contrasts with the all-metal seal example, in that the pressure applied to the belts is much more uniform and constant. Also, the bladder sealing effect is much more efficient; as the bladder is provided with a slip-seal surface comprising a metal strip coated with Teflon. This surface directly contacts the belts and allows for smooth running of the same. Direct contact between the belts and the rubber bladder is thus avoided. In the all-metal seal embodiment, a portion of the sealing pressure is contributed by the weight of the floating heating and cooling bars, and leakage of the seals can occur, particularly at the inlet and outlet ends of the laminator.

As described above, this invention may be used to manufacture non-woven fabrics using the preferred pressure lamination apparatus.

PCT Publication No. WO 00/41523 describes a non-woven warp yarn fabric material, which is one preferred substrate for lamination in the present invention. In general, the PCT Publication describes one preferred substrate for use in the pressure laminator of the present invention. The substrate of the PCT Publication comprises a plurality of yarns that are formed into an aligned group, substantially parallel and equally spaced apart, and held together by a hot melt adhesive applied to one side of the fiber group. This fiber orientation, in which the fibers run in the machine direction, creates a non-woven fabric material substrate in which the fibers mimic warp yarns, which can be combined with one or more woven or non-woven fiber substrates and pressure laminated to create finished products that have the visual impression and physical feel of a woven material.

PCT Publication No. WO 00/41523 also describes the formation of a preferred substrate material used in the pressure laminator of the present invention. In general, the PCT Publication describes an apparatus for fabricating a non-woven fabric composite, which has the appearance of a woven fabric. The apparatus includes a supply station for adhesive coated parallel warp yarns, a support structure for orienting the parallel warp yarns into a cylindrical orientation with the adhesive film on the outside, a weft yarn applicator for wrapping weft yarns around the cylindrically oriented warp yarns, a heating station for activating the adhesive and a cooling station for setting the adhesive, and a cutter for severing the cylindrically formed fabric composite so that it can be flattened and wrapped onto a take-up roller, for transfer to the pressure laminator of the present invention.

The weft yarn applicator disclosed in the PCT Publication includes a rotating drum wherein a plurality of spools of weft yarn material are mounted in circumferentially spaced relationship and a tensioner is provided for applying the weft yarn material around the warp yarns in a predetermined tension which may be the same as, greater than, or less than the tension in the warp yarns. A conical aligner assures that the weft yarns will be delivered to the warp yarn cylinder in substantially perpendicular alignment.

## Claims

1. A pressure lamination apparatus (400) comprising:
- a housing or frame;
- a pressure box (401) that is mounted in the housing or frame and comprises upper and lower pressurable sections (412,414) and a space between the upper and lower sections defining a lamination section;
- counter-rotating, upper and lower belts (402, 404) that are rotatably mounted in the housing or frame and that contact one another at, and pass in the same direction through, the lamination section; and
- a fluid medium pressure generator (602, 604) for supplying pressure to the upper and lower sections (412, 414) of the pressure box (401) for compressing the belts (402, 404) moving therebetween;
- whereby, depending upon the direction of rotation of the belts (402, 404), one end (416) of the lamination section acts as an inlet for substrates to be pressure laminated in the lamination section between the belts and an opposite end (418) acts as an outlet for pressure laminated substrates; and
- wherein the upper pressure box section (412) includes pressure seals (200) at the sides and the inlet and outlet ends (416, 418); .
**characterized in that** the pressure seals comprise bladders (200).

2. The apparatus of claim 1 wherein each bladder comprises a rubber bladder (200).

3. The apparatus of claim 1 or 2 wherein each bladder (200) is inflatable.

4. The apparatus of any one of claims 1-4 wherein a Teflon-coated, metal slip plate (210) is provided between each bladder (200) and one of the belts (402, 404).

5. The apparatus of any one of claims 1-4 wherein the lower pressure box section (414) also includes pressure seals (200) at the sides and the inlet and outlet ends (416, 418).

6. The apparatus of any one of claims 1-5 wherein heating and cooling elements (310A, 310B, etc. and 320A, 320B etc.) are within the upper and lower sections (412, 414) of the pressure box (401).

7. The apparatus of claim 6 wherein a heating element (310B, 310D, etc.) is within the upper section (412) of the pressure box (401).

8. The apparatus of claim 7 wherein the heating element (310B, 310D, etc.) in the upper section comprises a plurality of heating elements, a steam powered heating section or infra-red heating.

9. The apparatus of claim 6 wherein a cooling element (320B, 320D, etc.) is within the upper section (412) of the pressure box.

10. The apparatus of claim 9 wherein the cooling element (320B, 320D, etc.) in the upper section comprises a plurality of cooling elements.

11. The apparatus of claim 9 wherein the cooling element in the upper section comprises a cold water cooling section.

12. The apparatus of any one of claims 7-11 wherein heating and cooling elements are within the upper section of the pressure box.

13. The apparatus of any one of claims 6-12 wherein a heating element (310A, 310C, etc.) is within the lower section (414) of the pressure box (401).

14. The apparatus of claim 14 wherein the heating element in the lower section of the pressure box comprises a plurality of heating elements, a steam powered heating section or infra-red heating.

15. The apparatus of any one of claims 6-12 wherein a cooling element (320A, 320C, etc.) is within the lower section of the pressure box.

16. The apparatus of claim 15 wherein the cooling element in the lower section of the pressure box comprises a plurality of cooling elements.

17. The apparatus of claim 15 wherein the cooling element in the lower section of the pressure box comprises a cold water cooling section.

18. The apparatus of claim 16 wherein the plurality of cooling elements in the lower section of the pressure box is fixed in place.

19. The apparatus of any one of claims 16-20 wherein heating and cooling elements are within the lower section of the pressure box.

20. The apparatus of any one of claims 7-12 wherein the heating and cooling elements in the upper section of the pressure box are mounted so as to float on top of the upper belt.

21. The apparatus of claim 13 or 14 wherein the heating elements in the lower section of the pressure box are fixed in place.

22. The apparatus of any one of claims 7-21 wherein the heating and cooling elements are arranged in a staggered configuration.

23. The apparatus of any one of claims 1-22 wherein the lower section (414) of the pressure box is mounted rigidly to the housing or frame.

24. The apparatus of any one of claims 1-23 wherein the upper section (412) of the pressure box is mounted in an adjustable manner to the housing or frame.

25. The apparatus of any one of claims 1-24 wherein the belts (402, 404) are pressurized within a range of from about 2268 kg (5000 lbs) to about 22680 kg (50,000 lbs), over an area of about 967740 mm² (1500 square inches).

26. The apparatus of claim 25 wherein the belts (402, 404) are pressurized within a range of from about 4536 kg (10,000 lbs) to about 11340 kg (25,000 lbs), over an area of about 967740 mm² (1500 square inches).

27. The apparatus of any one of claims 1-26 further comprising an alignment system, including an electric eye, an alignment servo and an alignment carriage, wherein the electric eye is adapted to detect either of the drive belts moving out of alignment and capable of activating the alignment servo so as to cause the drive belts to be adjusted by lateral movement of the alignment carriage.

28. The apparatus of any one of claims 1-27 wherein the fluid medium pressure generator (602, 604) uses air, steam, water or oil.

29. The apparatus of claim 28 wherein a compressed air generator supplies pressure to the upper and lower sections (412, 414) of the pressure box for compressing the belts (402, 404).

## Patentansprüche

1. Doppelbandpresse (400) umfassend:
- ein Gehäuse oder einen Rahmen;
- eine Druckkammer (401), die in dem Gehäuse oder Rahmen befestigt ist und einen oberen und einen unteren, jeweils mit Druck beaufschlagbaren Abschnitt (412, 414) umfaßt, wobei ein zwischen den beiden Abschnitten gebildeter Raum einen Laminierungsabschnitt bildet;
- gegenläufig rotierende obere und untere Bänder (402, 404), die drehbar im Gehäuse oder Rahmen befestigt sind und sich im Laminierungsabschnitt berühren und in derselben Richtung durch den Laminierungsabschnitt laufen; und
- einen Fluid-Druckerzeuger (602, 604), der den oberen und den unteren Abschnitt (412, 414) der Druckkammer (401) mit Druck versorgt, um die Bänder (402, 404), die sich dazwischen bewegen, zusammenzudrücken;
- wobei, abhängig von der Drehrichtung der Bänder (402, 404) ein Ende (416) des Laminierungsabschnitts als Einführung für Substrate dient, die im Laminierungsabschnitt zwischen den Bändern unter Druck zu laminieren sind, und ein gegenüberliegendes Ende (418) als Auslaß für drucklaminierte Substrate dient; und
- wobei der obere Abschnitt (412) der Druckkammer an den Seiten und den Einführungs- und Auslaßenden (416, 418) Druckdichtungen (200) umfaßt, **dadurch gekennzeichnet, daß** die Druckdichtungen Bälge (200) umfassen.

2. Vorrichtung gemäß Anspruch 1, bei der jeder Balg einen Gummibalg (200) umfaßt.

3. Vorrichtung gemäß Anspruch 1 oder 2, bei der jeder Balg (200) aufblasbar ist.

4. Vorrichtung gemäß einem der Ansprüche 1 bis 4, bei der zwischen jedem Balg (200) und einem der Bänder (402, 404) eine mit Teflon beschichtete Metall-Gleitplatte (210) vorgesehen ist.

5. Vorrichtung gemäß einem der Ansprüche 1 bis 4, bei der der untere Abschnitt (414) der Druckkammer ebenfalls Druckdichtungen (200) an den Seiten und den Einführungs- und Auslaßenden (416, 418) umfaßt.

6. Vorrichtung gemäß einem der Ansprüche 1 bis 5, bei der Heiz- und Kühlelemente (310A, 310B usw. und 320A, 320B usw.) innerhalb des oberen und des unteren Abschnitts (412, 414) der Druckkammer (401) vorgesehen sind.

7. Vorrichtung gemäß Anspruch 6, bei der ein Heizelement (310B, 310D usw.) innerhalb des oberen Abschnitts (412) der Druckkammer (401) angeordnet ist.

8. Vorrichtung gemäß Anspruch 7, bei der das Heizelement (310B, 310D usw.) im oberen Abschnitt mehrere Heizelemente, eine dampfbetriebene Heizstrecke oder Infrarotheizung umfaßt.

9. Vorrichtung gemäß Anspruch 6, bei der ein Kühlelement (320B, 320D usw.) innerhalb des oberen Abschnitts (412) der Druckkammer angeordnet ist.

10. Vorrichtung gemäß Anspruch 9, bei der das Kühlelement (320B, 320D usw.) im oberen Abschnitt mehrere Kühlelemente umfaßt.

11. Vorrichtung gemäß Anspruch 9, bei der das Kühlelement im oberen Abschnitt eine Kaltwasser-Kühlstrecke umfaßt.

12. Vorrichtung gemäß einem der Ansprüche 7 bis 11, bei der Heiz- und Kühlelemente innerhalb des oberen Abschnitts der Druckkammer angeordnet sind.

13. Vorrichtung gemäß einem der Ansprüche 6 bis 12, bei der ein Heizelement (310A, 310C usw.) innerhalb des unteren Abschnitts (414) der Druckkammer (401) angeordnet ist.

14. Vorrichtung gemäß Anspruch 14, bei der das Heizelement im unteren Abschnitt der Druckkammer mehrere Heizelemente, eine dampfbetriebene Heizstrecke oder Infrarotheizung umfaßt.

15. Vorrichtung gemäß einem der Ansprüche 6 bis 12, bei der ein Kühlelement (320A, 320C usw.) innerhalb des unteren Abschnitts der Druckkammer angeordnet ist.

16. Vorrichtung gemäß Anspruch 15, bei der das Kühlelement im unteren Abschnitt der Druckkammer mehrere Kühlelemente umfaßt.

17. Vorrichtung gemäß Anspruch 15, bei der das Kühlelement im unteren Abschnitt der Druckkammer eine Kaltwasser-Kühlstrecke umfaßt.

18. Vorrichtung gemäß Anspruch 16, bei der die mehreren Kühlelemente im unteren Abschnitt der Druckkammer ortsfest sind.

19. Vorrichtung gemäß einem der Ansprüche 16 bis 20, bei der Heiz- und Kühlelemente innerhalb des unteren Abschnitts der Druckkammer angeordnet sind.

20. Vorrichtung gemäß einem der Ansprüche 7 bis 12, bei der die Heiz- und Kühlelemente im oberen Abschnitt der Druckkammer so montiert sind, daß sie frei auf dem oberen Band aufliegen.

21. Vorrichtung gemäß Anspruch 13 oder 14, bei der die Heizelemente im unteren Abschnitt der Druckkammer ortsfest sind.

22. Vorrichtung gemäß einem der Ansprüche 7 bis 21, bei der die Heiz- und Kühlelemente versetzt angeordnet sind.

23. Vorrichtung gemäß einem der Ansprüche 1 bis 22, bei der der untere Abschnitt (414) der Druckkammer starr an dem Gehäuse oder Rahmen befestigt ist.

24. Vorrichtung gemäß einem der Ansprüche 1 bis 23, bei der der obere Abschnitt (412) der Druckkammer verstellbar an dem Gehäuse oder Rahmen befestigt ist.

25. Vorrichtung gemäß einem der Ansprüche 1 bis 24, bei der die Bänder (402, 404) auf einer Fläche von etwa 967.740 mm² (1.500 Quadratzoll) mit einem Druck im Bereich von etwa 2.268 kg (5.000 lbs) bis etwa 22.680 kg (50.000 lbs) beaufschlagt werden.

26. Vorrichtung gemäß Anspruch 25, bei der die Bänder (402, 404) auf einer Fläche von etwa 967.740 mm² (1.500 Quadratzoll) mit einem Druck im Bereich von etwa 4.536 kg (10.000 lbs) bis etwa 11.340 kg (25.000 lbs) beaufschlagt werden.

27. Vorrichtung gemäß einem der Ansprüche 1 bis 26, weiter umfassend ein Ausrichtungssystem mit einem elektrischen Auge, einem Ausrichtungs-Servomotor und einem Ausrichtungsschlitten, wobei das elektrische Auge dafür vorgesehen ist zu erkennen, wenn sich eins der Antriebsbänder von der korrekten Ausrichtung entfernt, und in der Lage ist, den Ausrichtungs-Servomotor anzusteuern, so daß die Antriebsbänder durch seitliche Bewegung des Ausrichtungsschlittens nachgestellt werden.

28. Vorrichtung gemäß einem der Ansprüche 1 bis 27, bei der der Fluid-Druckerzeuger (602, 604) Luft, Dampf, Wasser oder Öl verwendet.

29. Vorrichtung gemäß Anspruch 28, bei der ein Drucklufterzeuger den oberen und den unteren Abschnitt (412, 414) der Druckkammer mit Druck versorgt, um die Bänder (402, 404) zusammenzupressen.

## Revendications

1. Dispositif de stratification sous pression (400) comprenant :
- une enceinte ou une structure ;
- un caisson à pression (401) qui est monté dans l'enceinte ou dans la structure et qui comporte des sections pressurisables supérieure et inférieure (412, 414), un espace entre les sections supérieure et inférieure définissant une section de stratification ;
- des courroies supérieure et inférieure (402, 404) tournant en sens inverse qui sont montées à rotation dans l'enceinte ou la structure et sont en contact l'une avec l'autre au niveau de la section de stratification et qui traversent cette dernière dans la même direction ; et
- un générateur de fluide à pression moyenne (602, 604) pour fournir une pression aux sections supérieure et inférieure (412, 414) du caisson à pression (401) pour comprimer les courroies (402, 404) se déplaçant entre elles ;
- de sorte que, en fonction de la direction de rotation des courroies (402, 404), une extrémité (416) de la section de stratification agisse comme un orifice d'entrée pour des substrats à être stratifiés sous pression dans la section de stratification entre les courroies et une extrémité opposée (418 agisse comme un orifice de sortie pour les substrats stratifiés sous pression ; et
- dans lequel la section supérieure du caisson à pression (412) comprend des joints d'étanchéité à la pression (200) au niveau des côtés et des extrémités d'entrée et de sortie (416, 418) ; **caractérisé en ce que** les joints d'étanchéité tenant à la pression comportent des vessies (200).

2. Dispositif selon la revendication 1 dans lequel chaque vessie comprend une vessie en caoutchouc (200).

3. Dispositif selon la revendication 1 ou 2 dans lequel chaque vessie (200) est gonflable.

4. Dispositif selon l'une quelconque des revendications 1 à 4 dans lequel une plaque de glissement métallique, recouverte de Teflon (210) est fournie entre chaque vessie (200) et l'une des courroies (402, 404).

5. Dispositif selon l'une quelconque des revendications 1 à 4 dans lequel la section inférieure du caisson à pression (414) comporte également des joints d'étanchéité tenant à la pression (200) au niveau des côtés et des extrémités d'entrée et de sortie (416, 418).

6. Dispositif selon l'une quelconque des revendications 1 à 5 dans lequel des éléments de chauffage et de refroidissement (310A, 310B etc. et 320A, 320B etc.) se trouvent à l'intérieur des sections supérieure et inférieure (412, 414) du caisson à pression (401).

7. Dispositif selon la revendication 6 dans lequel un élément chauffant (310B, 310D, etc.) est placé à l'intérieur de la section supérieure (412) de la boîte à pression (401).

8. Dispositif selon la revendication 7 dans lequel l'élément chauffant (310B, 310D, etc.) de la section supérieure comporte une pluralité d'éléments chauffants, une section chauffante alimentée par vapeur ou par un chauffage à infrarouge.

9. Dispositif selon la revendication 6 dans lequel un élément de refroidissement (320B, 320D) se trouve à l'intérieur de la section supérieure (412) du caisson à pression.

10. Dispositif selon la revendication 9 dans lequel l'élément de refroidissement (320B, 320D, etc.) de la section supérieure comporte une pluralité d'éléments de refroidissement.

11. Dispositif selon la revendication 9 dans lequel l'élément de refroidissement de la section supérieure comprend une section de refroidissement à l'eau froide.

12. Dispositif selon l'une quelconque des revendications 7 à 11 dans lequel les éléments chauffants et de refroidissement se trouvent à l'intérieur de la section supérieure du caisson à pression.

13. Dispositif selon l'une quelconque des revendications 6 à 12 dans lequel un élément chauffant (310A, 310C, etc.) se trouve à l'intérieur de la section inférieure (414) du caisson à pression (401).

14. Dispositif selon la revendication 13 dans lequel l'élément chauffant de la section inférieure du caisson à pression comporte une pluralité d'éléments chauffants, une section de chauffage alimentée par vapeur ou un chauffage à infrarouge.

15. Dispositif selon l'une quelconque des revendications 6 à 12 dans lequel un élément de refroidissement (320A, 320C, etc.) se trouve à l'intérieur de la section inférieure du caisson à pression.

16. Dispositif selon la revendication 15 dans lequel l'élément de refroidissement de la section inférieure du caisson à pression comprend une pluralité d'éléments de refroidissement.

17. Dispositif selon la revendication 15 dans lequel l'élément de refroidissement de la section inférieure du caisson à pression comporte une section de refroidissement à l'eau froide.

18. Dispositif selon la revendication 16 dans lequel la pluralité d'éléments de refroidissement de la section inférieure du caisson à pression est fixée en place.

19. Dispositif selon l'une quelconque des revendications 16 à 20 dans lequel les éléments de chauffage et de refroidissement se trouvent à l'intérieur de la section inférieure du caisson à pression.

20. Dispositif selon l'une quelconque des revendications 7 à 12 dans lequel les éléments de chauffage et de refroidissement de la section supérieure du caisson à pression sont montés de façon à flotter sur le dessus de la courroie supérieure.

21. Dispositif selon la revendication 13 ou 14 dans lequel les éléments chauffants de la section inférieure du caisson à pression sont fixés en place.

22. Dispositif selon l'une quelconque des revendications 1 à 22 dans lequel les éléments chauffants et de refroidissement sont disposés selon une configuration en quinconce.

23. Dispositif selon l'une quelconque des revendications 1 à 22 dans lequel la section inférieure (414) du caisson à pression est montée de façon rigide sur l'enceinte ou sur la structure.

24. Dispositif selon l'une quelconque des revendications 1 à 23 dans lequel la section supérieure (412) du caisson à pression est montée d'une façon pouvant être ajustée sur l'enceinte ou sur la structure.

25. Dispositif selon l'une quelconque des revendications 1 à 24 dans lequel les courroies (402, 404) sont mises sous pression à l'intérieur d'une plage allant de 2268 kg (5000 lbs) environ à 22680 kg (50 000 lbs) environ, sur une surface de 967740 mm² environ (1500 pouces carrés).

26. Dispositif selon la revendication 25 dans lequel les courroies (402, 404) sont mises sous pressions dans une plage allant de 4536 kg (10 000 lbs) environ à 11 340 kg (25 000 lbs) environ, sur une surface d'environ 967740 mm² (1500 pouces carrés).

27. Dispositif selon l'une quelconque des revendications 1 à 26 comprenant, de plus, un système d'alignement, comportant un oeil électrique, un servomécanisme d'alignement et un chariot d'alignement, dans lequel l'oeil électrique est adapté pour détecter si l'une ou l'autre des courroies d'entraînement se déplace hors de l'alignement et est capable d'activer le dispositif de servomécanisme d'alignement de façon à entraîner les courroies d'entraînement à être réajustées par un déplacement latéral du chariot d'alignement.

28. Dispositif selon l'une quelconque des revendications 1 à 27 dans lequel le générateur de fluide à pression moyenne (602, 604) utilise de l'air, de la vapeur, de l'eau ou de l'huile.

29. Dispositif selon la revendication 28 dans lequel un générateur d'air comprimé fournit de la pression aux sections supérieure et inférieure (412, 414) du caisson à pression pour comprimer les courroies (402, 404).
